# EUROPEAN PATENT SPECIFICATION

(11) **EP 0 947 604 B1**
(45) Date of publication and mention of the grant of the patent: **28.11.2001**
(21) Application number: 98109081.4
(22) Date of filing: 19.05.1998
(51) Int. Cl.: C23C 16/02, H01L 21/316

(54) **Method for reforming a substrate surface**
Methode zum Umformen einer Substratoberfläche
Méthode pour modifier la surface d'un substrat

(30) Priority: 06.02.1998 JP 2626598
(43) Date of publication of application: 06.10.1999
(73) Proprietor: SEMICONDUCTOR PROCESS LABORATORY CO., LTD., Minato-ku, Tokyo 108 (JP)
(72) Inventor: Maeda, Kazuo, Kamakura-shi, Kanagawa 248 (JP)
(74) Representative: Schwabe - Sandmair - Marx

(56) References cited:
- GB-A- 1 044 041
- US-A- 5 080 933
- US-A- 5 365 877
- JEN-CHUNG LOU ET AL: "DICHLOROSILANE EFFECTS ON LOW-TEMPERATURE SELECTIVE SILICON EPITAXY" APPLIED PHYSICS LETTERS, vol. 58, no. 1, 7 January 1991, pages 59-61, XP000201719

## Description

### BACK GROUND OF THE INVENTION

### 1. Field of the Invention

The present invention relates to a method for reforming a base surface before thin film deposition, a method for manufacturing the semiconductor device and an equipment for manufacturing the same, and more particularly to the method for reforming the base surface before the thin film deposition, the method for manufacturing the semiconductor device and the equipment for manufacturing the same in the thin film deposition by CVD (Chemical Vapor deposition) method using O₃/TEOS (Tetraehylorthosilicate) system reaction gas (the gases containing O₃ and TEOS).

### 2. Description of the Prior Art

Recently, it is often known that a property of the film formed on the base layer is greatly influenced depending upon a surface condition of the base layer.

Especially, a film property of CVD film deposited by the CVD method using O₃/TEOS system gas for thin film deposition depends upon the surface condition of the base layer greatly. For example, the growth rate of the thin film is reduced remarkably and the deposited film becomes porous in case that the surface of the base layer is hydrophilic.

Therefore, the fluidity, the flatness, the embedding ability and the step-coverage ability of the film deposited on a surface of a base layer are lowered.

It is thought that such deposition irregularity is caused by that an intermediate generated in the reaction of O₃ gas and TEOS gas is a polymer with hydrophilicity, and it is shown that a film can not be deposited on the surface of the base layer in case that the surface of the base layer is hydrophilic.

As methods destroying a dependence on the surface of the base layer described above, there have been
(1)a method by plasma processing using the gases such as NH₃, H₂ or the like,
(2)a method using the insulating film formed using a low concentration of O₃ as the base layer,
(3)a method using the insulating film formed by a plasma CVD method as the base layer,
(4)a method processing the surface of the base layer before the thin film deposition with alcohol, or the like.

However, there are the problems as described below in the mentioned-above method. That is,
(1)In the method by plasma processing using the gases such as NH₃, H₂ or the like the good film in the embedding ability and the step-coverage ability has been not deposited, when depositing film on very narrow regions such as via-holes and contact holes.
(2)In the method using the insulating film formed by a plasma CVD method as the base layer, it has been difficult to form the insulating film being used as the base layer on the very narrow regions such as the via-holes and the contact holes.
(3)In also the method using the insulating film formed by the plasma CVD method as the base layer, it has been difficult to form the insulating film being used as the base layer on the very narrow regions such as the via-holes and the contact holes as the same as the item (2). (4)In the method processing the surface of the base layer before the thin film deposition with alcohol, the effect of reform is poor in reproduction, in addition, the effect of reform processing of the base surface can not be maintained.

From US-A 5,080,933 a method for selectively depositing polysilicon on a semiconductor surface is known. In this method, after a silicon substrate is exposed to a single crystal inhibitor gas, a polycrystalline silicon is formed on the silicon substrate exposing to a silicon containing gas and a source of hydrogen. N₂ or Ar is used as the single crystal inhibitor gas. Furthermore, SiHₙCl₄₋ₙ by which the polycrystalline silicon can be selectively formed on the silicon substrate is used as the silicon containing gas.

US-A-5,365,877 describes a method for forming a semiconductor layer on a semiconductor substrate in which the semiconductor layer is formed on the semiconductor substrate rotating the semiconductor substrate. SiHₙCl₄₋ₙ is used as a reaction gas.

GB-A 1,044,041 describes a method of manufacturing semiconductor devices in which, after a semiconductor layer is formed on a semiconductor substrate, a silicon oxide film is formed on the semiconductor layer continuously without taking it outside the film forming apparatus. SiH₄ or SiHCl₃ is used as a film forming gas.

From the article "Dichlorosilane effects on low-temperature selective silicon epitaxy", Applied Physics Letters 58 (1991), 7 January, no. 1, New York, US, a method for forming a silicon layer on a silicon film forming surface is known. It is disclosed that the silicon film forming surface is process by a process gas in which a low concentration of SiH₂Cl₂ is added in H₂ gas before the film formation of this silicon layer on a silicon film forming surface.

### Summary of the Invention

The present invention is defined by the features of the independent claims. Advantageous embodiments of the present invention are set forth in the subclaims.

The object of the invention is to provide a method for reforming a base surface before the thin film deposition, a method for manufacturing the semiconductor device and an equipment for manufacturing the same, capable of maintaining the effect by means reform of the base layer surface, of improving the fluidity, the flatness, the embedding ability and the step-coverage ability of the film deposited on the surface of the base layer and, especially, of improving the embedding ability and the step-coverage ability of the film formed in the very narrow regions such as the via-holes and the contact holes of the base layer.

In the invention, reform of the surface of the base layer in a reaction chamber is performed by the gas for reform of the base layer surface containing a halogen element, and subsequently, film deposition can be performed on the surface of the base layer reformed by the gas for thin film deposition.

According to experiments of the inventor of this application, it has been found that when reform of the surface of the base layer is performed by the gas for reform of the base layer surface containing a halogen element, the effect of reform of the base layer surface can be maintained for the long term as compared to the prior art, in addition, the fluidity, the flatness, the embedding ability and the step-coverage ability of the film formed on the reformed surface of the base layer can be improved.

Especially, the embedding ability and the step-coverage ability of the film formed in the via-holes or the like could be improved, even though there are the very narrow-concave regions such as the via-holes and the contact holes in the base layer.

Moreover, the fluidity, the flatness, the embedding ability and the step-coverage ability of the film formed on the surface of the base layer thereof can be improved, when reform of the surface of the base layer is performed while heating the base layer.

Especially, it was confirmed that the effect further can be increased when setting a heating temperature at 100 °C or more upon reform of the surface.

### BRIEF DESCRIPTION OF THE DRAWINGS

FIG. 1A to FIG. 1C are sectional views showing a method for reforming a base surface of embodiment of the invention.

FIG. 2 is a view showing a condition of a base thermal SiO₂ film surface soon after forming the base thermal SiO₂ film, according to the method for reforming the base surface of the embodiment of the invention.

FIG. 3A and FIG. 3B are views showing a condition of the base thermal SiO₂ film surface before reforming according to the method for reforming the base surface of the embodiment according to the invention.

FIG. 4A to FIG. 4F are views showing a reaction of the base thermal SiO₂ film and a reaction gas SiCl₄ according to the method for reforming the base surface of the embodiment according to the invention.

FIG. 5 is a schematic construction view showing a CVD thin film deposition equipment of a cold wall system, which can be used in the method for reforming the base surface of the invention.

FIG. 6 is a side view showing a detail of reforming gas supply means provided on the equipment for manufacturing the semiconductor device for use in the invention.

FIG. 7A and FIG. 7B are section views showing a reaction equipment of a hot wall system which can be used as the equipment for manufacturing the semiconductor device employing the embodiment of the invention.

FIG. 8 is a section view in case of that a O₃/TEOS SiO₂ film is formed after reform processing according to the embodiment of the invention.

FIG. 9 is a section view in case of that a O₃/TEOS SiO₂ film is formed without performing reform processing of the base surface according to the comparison example.

### DESCRIPTION OF THE PREFERRED EMBODIMENT

Hereinafter, the embodiment of the invention will be described referring to the accompanying drawings.

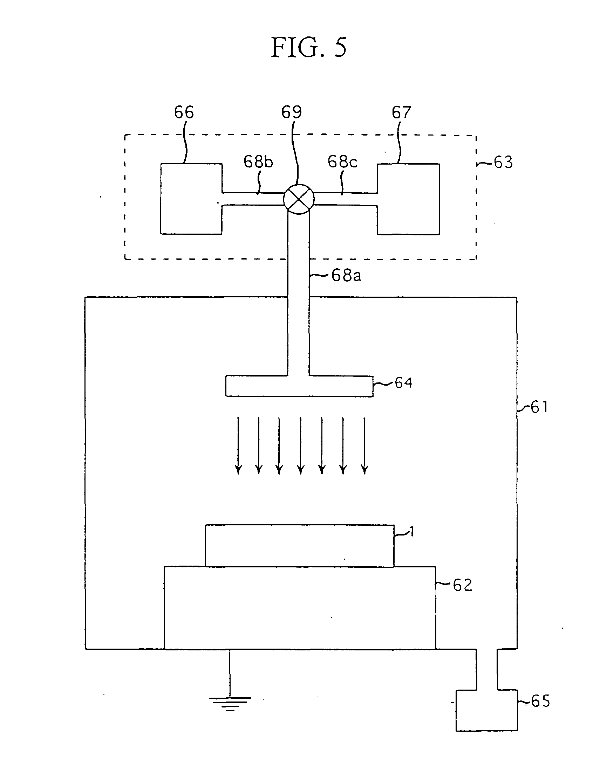

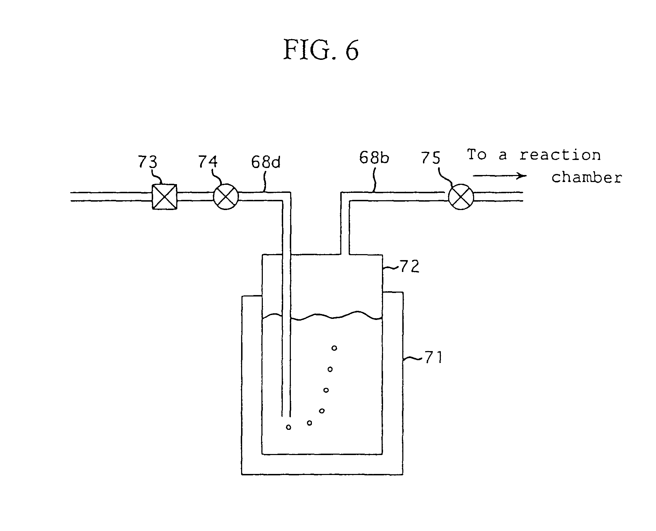

FIG. 5 is a schematic construction view showing a CVD thin film deposition equipment of a cold wall system which can be used in the method for reforming the base surface of the present invention and FIG. 6 is a side view showing detail of reforming gas supplying bombe.

A holding table 62 for holding a silicon wafer 1 is provided in a reaction chamber 61 ( a chamber) made of stainless steel, and a heater (a heating means) for heating the silicon wafer 1 is embedded in the holding table 62.

A conduit 68a introducing the O₃/TEOS gases (gases for thin film deposition) supplied from a gas supply means 63 or the gas for reforming the base layer surface into the reaction chamber 61 and a gas distribution plate 64 discharging the O₃/TEOS gases or the gas for reforming the base layer surface to the silicon wafer 1 on the holding table 62, said the gas distribution plate 64 being connected to the other end of said conduit 68a, are installed in the reaction chamber 61. Moreover, an exhaust equipment 65 for adjusting a pressure in the reaction chamber 61 is connected to the reaction chamber 61.

The gas supply means 63 is comprised of a reforming gas supply means 66, a supply means of the gas for thin film deposition 67, a conduit 68b and a selecting valve 69 (a selection means).

The reforming gas supply means 66 supplies the reforming gas in the reaction chamber 61 upon reforming the base surface, and the supply means 67 of the gas for thin film deposition supplies a mixed gas of the O₃ /TEOS gases of the gas for thin film deposition after reforming the surface of the base layer.

The conduit 68b and 68c are connected to these two gas supply means 66 and 67 respectively, in addition, these conduits 68b and 68c are connected with the conduit 68a extending into the reaction chamber 61.
The connecting ports of these three conduits 68b 68c and 68a are provided with the selecting valve 69 and the valve selects a flow passage so as to allow to conduct the flow passage introducing the gas for reforming from the conduit 68b to the conduit 68a or to conduct the flow passage introducing the gas for thin film deposition from the conduit 68c to the conduit 68a.

The gas for reforming or the gas for thin film deposition are introduced into the reaction chamber 61 through the conduit 68a selectively by selection of the flow passage by the selecting valve 69.

The detailed structure of the reforming gas supply means 66 is as follows:
namely, the reforming gas supply means 66 comprises an evaporation container 72 in which liquid sources such as liquid SiCl₄, SiBr₄, SiF₄ are accommodated and a temperature regulator 71 for adjusting a temperature of the liquid sources in the evaporation container 72, said the temperature regulator being provided around the evaporation container 72 as shown in FIG. 6. Moreover, the reforming gas supply means 66 comprises the conduit 68d for introducing N₂, H₂ or Ar gas as carrier gas into the liquid sources in the reaction container 72 and the conduit 68b introducing a source gas (a reforming gas) generated by allowing to bubble the carrier gas in the liquid sources outside the evaporation container 72. A flow meter 73 for measuring flow rate of N₂, H₂ or Ar gas and a valve 74 for performing flow regulation are provided on the conduit 68d and a valve 75 for performing flow regulation of the reforming gas is provided on the conduit 68b. The reforming gas generated in the evaporation container 72 is introduced into the reaction chamber 61 through the conduit 68b.

Subsequently, the method for reforming the base surface of the embodiment of the present invention will be described.

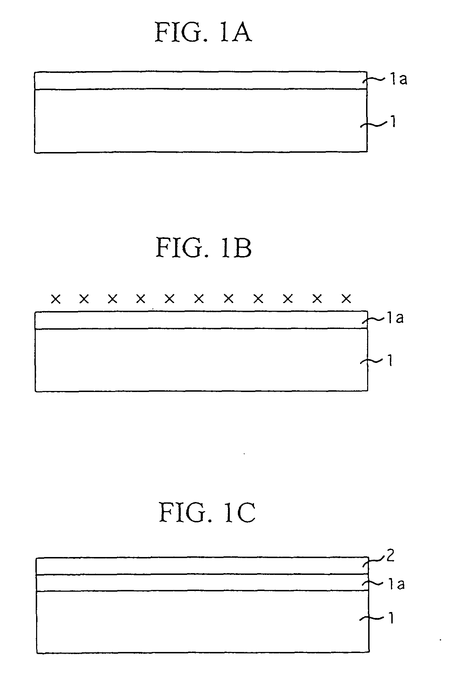

FIG. 1A to FIG. 1C are sectional views showing a method for reforming a base surface of embodiment of the present invention.

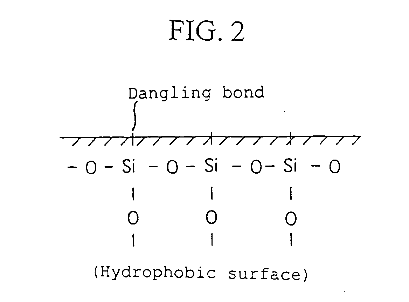

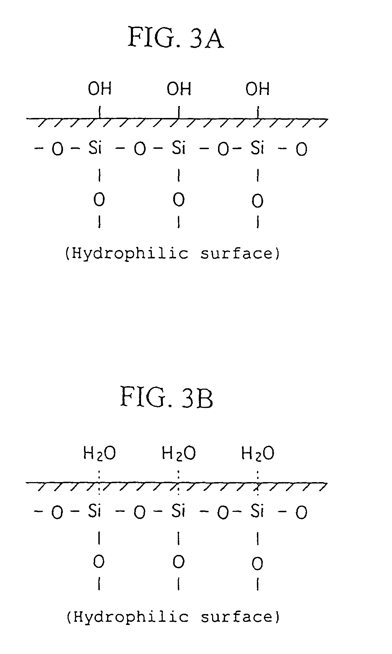

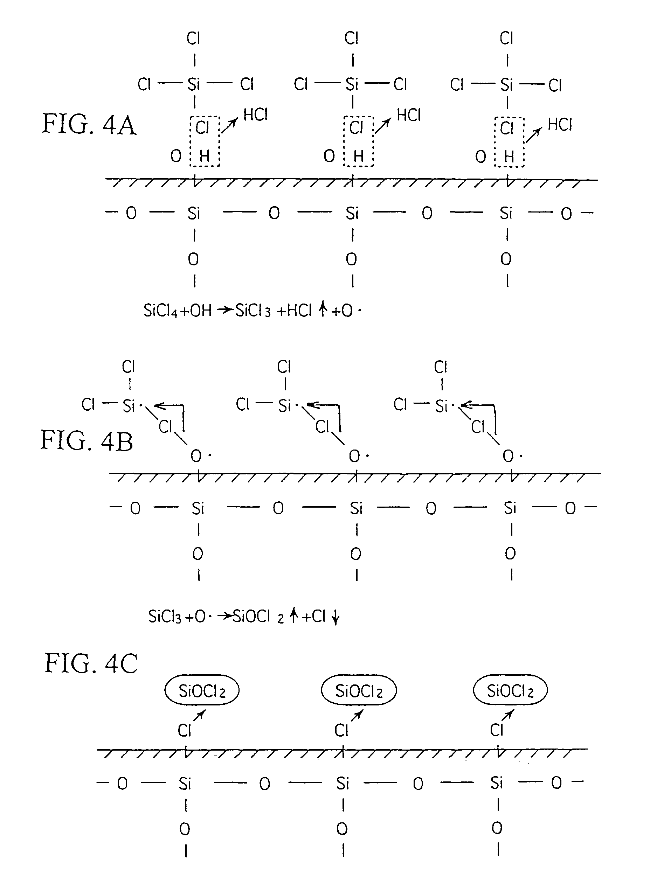

FIG. 2 is a view showing a condition of a base thermal SiO₂ film surface soon after forming the thermal SiO₂ film as the base layer (hereinafter referred to as a base thermal SiO₂ film also) is formed, FIG. 3A and FIG. 3B are views showing a conditions of the base thermal SiO₂ film surface before reforming and FIG. 4A to FIG. 4E are views showing a reaction of the base thermal SiO₂ film and the reforming gas SiCl₄ at the base thermal SiO₂ film surface.

First, the silicon wafer 1 is fed in an oxidation furnace to be heated at 1100 °C within an oxygen atmosphere. By this treatment, the surface of the silicon wafer 1 is oxidized, whereby the thermal SiO₂ film 1a is formed as shown in FIG. 1A. This thermal SiO₂ film 1a becomes the base layer for thin film deposition. There are dangling bonds in Si of the surface of a base thermal SiO₂ film 1a soon after being formed as shown in FIG. 2.

In this process, a plasma enhanced CVD method and a low pressure CVD method may be used. At this point of time, it is considered that there are occurred the conditions that the surface of the base thermal SiO₂ film 1a contacts with air (containing moisture) to hydrate to allow to bond Si and OH to form Si-OH bond as shown in FIG. 3A, or to allow to bond Si and H₂O to form Si-H₂O bond as shown in FIG. 3B. In any events, the base thermal SiO₂ film 1a becomes hydrophilic.

Subsequently, the silicon wafer 1 is placed on the holding table 62 in the reaction chamber 61 as shown in FIG. 1B to be heated 100 °C or more by the heater built in the holding table 62. And then, the gas for reforming the base layer surface containing SiCl₄ is supplied from the reforming gas supply means 66 to the reaction chamber 61. The gas for reforming the base layer surface is discharged to the surface of the base thermal SiO₂ film 1a formed on the silicon wafer 1.

At this time, it can be estimated that two kind of reactions are occurred between the base thermal SiO₂ film 1a and the gas for reforming the base layer surface on the surface of the base thermal SiO₂ film 1a as described below. A mark "×" in FIG. 1B shows the situation that this reaction is occurred.

The situation of the reaction is described, dividing into the base thermal SiO₂ film 1a terminated by the Si-OH bond and the surface of the base thermal SiO₂ film 1a terminated by the Si-H₂O bond.

First, the situation of the reaction of the case being terminated by the Si-OH bond is illustrated.

As shown in FIG. 4A, -H in -OH being bonded by Si-OH bond and -Cl in SiCl₄ are bonded on the surface of the heated base thermal SiO₂ film 1a by being exposed to SiCl₄ to generate HCl. By this reaction, O remains in the bond of Si of the surface of the base thermal SiO₂ film 1a, as well as -Cl is removed from SiCl₄ to generate SiCl₃. Moreover, HCl generated is discharged out of the reaction region of the surface of the base thermal SiO₂ film 1a, since the temperature of the surface of the base thermal SiO₂ film 1a is 100 °C or more. ${\text{SiCl}}_{\text{4}} {\text{+OH}}^{\text{-}} {\text{→ SiCl}}_{\text{3}} {\text{+ HCl + O}}^{\text{2-}} \text{.}$

Oxygen and Si of the surface of the base thermal SiO₂ film 1a are bonded to result in SiO.

Subsequently, SiCl₃ generated and Si-O of the surface of the base thermal SiO₂ film 1a react as shown in FIG. 4B, whereby Cl and O are replaced to generate SiOCl₂ and Si-Cl as shown in FIG. 4C. ${\text{SiCl}}_{\text{3}} {\text{+ O}}^{\text{2-}} {\text{→ SiOCl}}_{\text{2}} {\text{+ Cl}}^{\text{-}} \text{.}$

By this reaction, hydrophobicity is appeared, since the surface of the base thermal SiO₂ film 1a is halogenated.

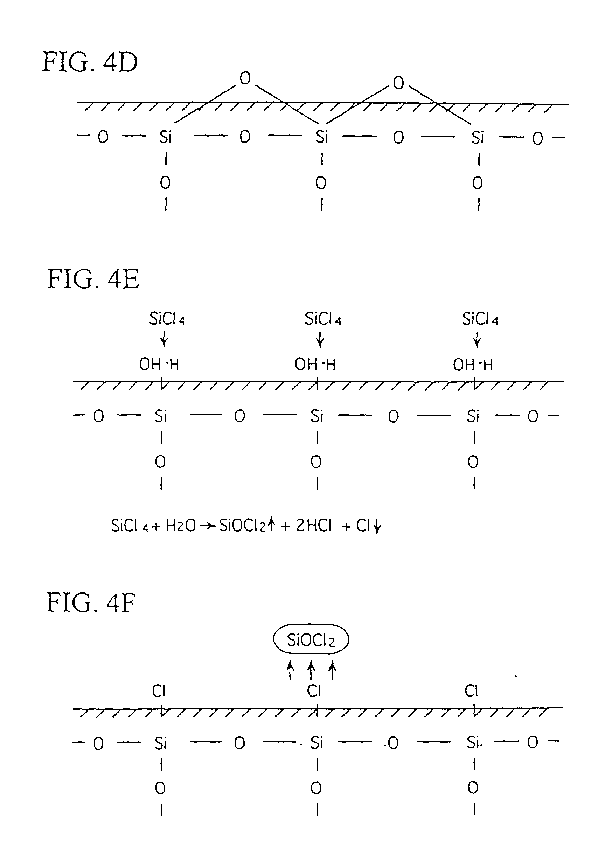

Furthermore, even though Cl and O are remained as it is without being replaced, hydrophobicity is shown since the surface is oxidized as shown in FIG. 4D.

Under the condition that Si of the surface of the base thermal SiO₂ film 1a is bonded with H₂O, SiCl₄ and H₂O react as shown in FIG. 4E to generate SiOCl₂, HCl and Cl through the same reaction processes as described in FIG. 4A to FIG. 4D. ${\text{SiCl}}_{\text{4}} {\text{+ H}}_{\text{2}} {\text{O → SiOCl}}_{\text{2}} {\text{+ 2HCl + Cl}}^{\text{-}}$

As a result, it is considered that since Si of the surface of the base thermal SiO₂ film 1a and Cl are bonded and the surface of the base thermal SiO₂ film 1a is chlorinated as shown in FIG. 4F, whereby hydrophobicity is appeared.

After the reform processing described above, without providing processing such as cleaning on the surface of the base thermal SiO₂ film 1a, the transfer to a subsequent thin film deposition process can be performed. Therefore, the reforming gas is stopped in succession the reform processing described above, and the mixed gas of the O₃/TEOS gases is supplied into the reaction chamber 61 as the gas for thin film deposition from the supply means 67 of the gas for thin film deposition.

Moreover, the silicon wafer 1 is heated at approximate 400 °C to allow to react the O₃ and TEOS gases thermally.

Holding the condition for the given time period, an O₃/TEOS SiO₂ film 2 is formed on the base thermal SiO₂ film 1a as shown in FIG. 1. This O₃/TEOS SiO₂ film 2 shows the SiO₂ film formed by making to react the O₃ gas and the TEOS gas.

In this embodiment, the thin film deposition is performed using the gases after reforming the surface of the base thermal SiO₂ film 1a into hydrophobic, whereby the fluidity, the flatness, the embedding ability and the step-coverage ability of O₃/TEOS SiO₂ film 2 formed can be improved.

Especially, it has allowed to maintain the effect of the reform since using the reforming gas containing a halogen element. That is, even though after performing reform of the base surface, the surface of the base thermal SiO₂ film 1a is exposed to air for 24 hours subsequently to form the O₃/TEOS SiO₂ film 2, the fluidity, the flatness, the embedding ability and the step-coverage ability of the O₃/TEOS SiO₂ film 2 formed can be maintained.

Hydrophobicity can be improved, since the temperature of the surface of the base thermal SiO₂ film 1a is 100 °C or more. In this case, it is considered that silanol (here, Si(OH)₄ is applicable) is generated in reforming process, and silanol is decomposed by the temperature of 100 °C or more. Moreover, when silanol is generated it takes long time to decompose silanol if being less than 100 °C, so that the time period to stay on the surface of the base thermal SiO₂ film 1a becomes long, whereby conversion from hydrophilicity to hydrophobicity becomes difficult.

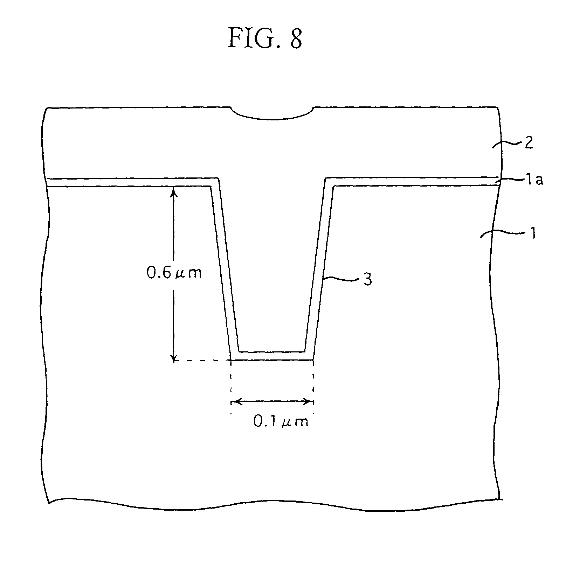

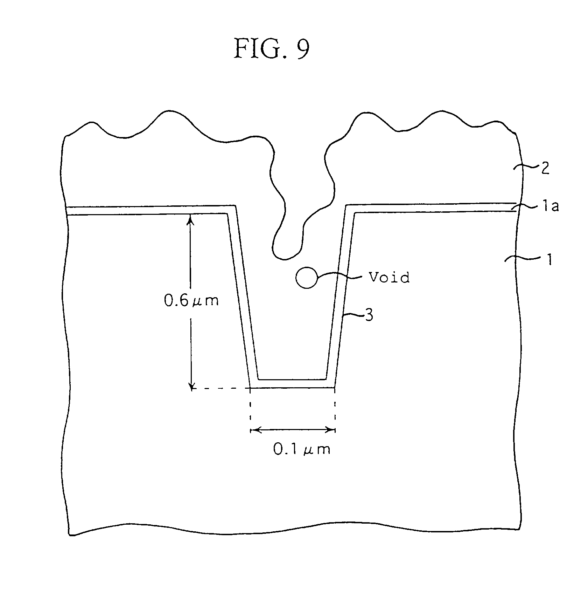

Hereinafter, the example actually embodied will be described referring to the FIG. 8. In this example, the invention is applied to the base layer in which there are grooves narrow in width. Moreover, for comparison, a comparison example deposited on the base layer without performing reform processing of the invention is shown in FIG. 9.

FIG. 8 is a section view in case of that a O₃/TEOS SiO₂ film is formed after performing reform processing on the base surface, and FIG. 9 is a section view in case of that a O₃/TEOS SiO₂ film is formed without performing reform processing of the base surface.

As shown in FIG. 8, a groove 3 of approximate 0.1*µ*m in width and approximate 0.6 *µ*m in depth was formed on the silicon wafer 1 to form the base thermal SiO₂ film 1a on the surface of the silicon wafer 1 having this groove 3 to provide as the base layer. And then, the O₃/TEOS SiO₂ film 2 is formed on the base layer surface thereof, and it was searched whether the embedding ability and the step-coverage ability of the O₃/TEOS SiO₂ film 2 formed could be improved or not.

Heating temperature is set at 1100 °C in order to form the base thermal SiO₂ film 1a.

As the conditions for reform of the base surface, liquid SiCl₄ in 20 °C was used as a liquid source, and bubbling was performed for about 2 minutes by introducing N₂ gas into this SiCl₄ at the rate of 5 littler per min.. Moreover, heating temperature of the silicon wafer 1 was set at 250 °C.

Moreover, in the conditions for thin film deposition of the O₃/TEOS SiO₂ film 2, the ozone concentration in the gas for thin film deposition composed of the mixed gas of the O₃/TEOS was set at a so called high concentration of O₃ concentration of 5 percent in O₂, and heating temperature of the silicon wafer 1 was set at 400 °C.

It is found from FIG. 8 that the O₃/TEOS SiO₂ film 2 of which surface is planarized is formed without voids, when the O₃/TEOS SiO₂ film 2 is formed after performing the processing using the method for reforming the base surface of this embodiment.

In contrast with this, it is found that the voids are occurred, the surface of the film 2 becomes wavy, whereby a planarized film can not be obtained as shown in FIG.9, when the O₃/TEOS SiO₂ film 2 is formed without reform processing of the base surface.

As described above, the embedding ability and the step-coverage ability of the film 2 formed in the groove 3 can be improved, when the surface reform of the base layer 1a having the very narrow-concave regions such as the groove 3 is performed by the gas for reform of the base layer surface containing a halogen element.

In this embodiment, although the same chamber 61 is used without separating the reaction chamber used for reforming the base surface and the reaction chamber used for depositing the O₃/TEOS SiO₂ film 2, an individual reaction chamber may be used respectively.

Moreover, the reaction chamber 61 may be a single wafer processing reaction chamber or a batch processing equipment of a furnace type.

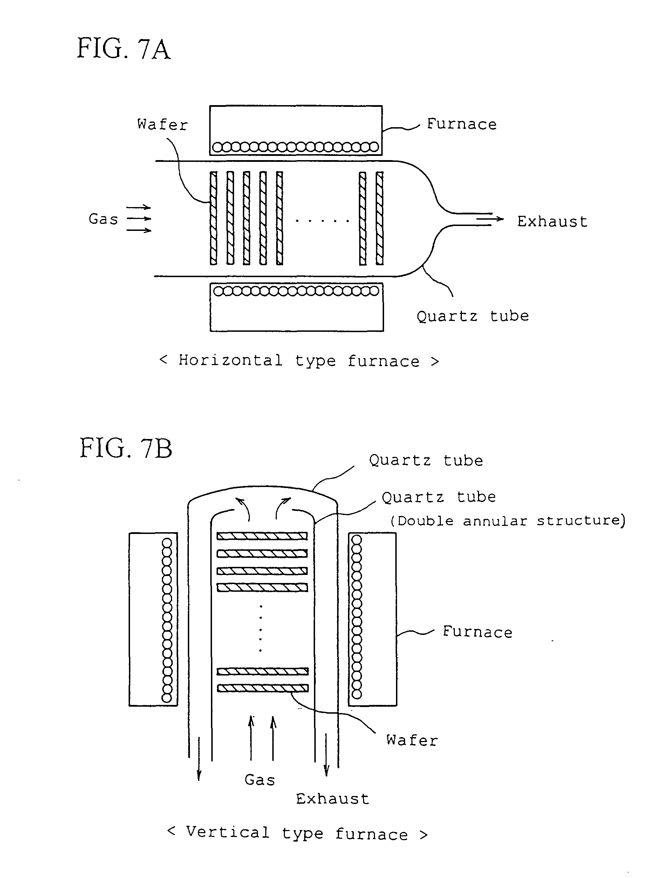

Furthermore, although the reaction equipment of a cold wall system is used in this embodiment, the reaction equipment may be a reaction equipment of a hot wall system as shown in FIG. 7 and a horizontal type furnace as shown in FIG. 7A or a vertical type furnace as shown in FIG. 7B.

In this case, a heater or an infrared heating equipment provided on the vicinity of the reaction chamber can be used as the heating means of the hot wall system.

Besides, although SiCl₄ in the gas expressed by a generalized formula AX₄ is used as the reforming gas, the other gas, for example, SiI₄, SiBr₄ or SiF₄ expressed by a generalized formula AX₄ can be used. Furthermore, the gas, for example, SiHCl₃, SiH₂Cl₂ or SiH₃Cl expressed by a generalized formula AHₙCl₄₋ₙ (the accompanying character "n" is any one of 1, 2 or 3) can be used. Moreover, the gas, for example, Si(CₘH₂ₘ₊₁)Cl₃, Si(CₘH₂ₘ₊₁)₂Cl₂, Si(CₘH₂ₘ₊₁)₃Cl expressed by a generalized formula ARₙX₄₋ₙ (the accompanying character "m" is a natural number) can be used.

Moreover, in the generalized formula described above, A represents any one of Si , Ge or Sn, X represents any one of I, Br, F or Cl and R represents any one of CₘH₂ₘ₊₁.

Furthermore, although SiO₂ film is used as the insulating film formed on the base layer, any one of PSG (Phosphosilicate glass) film, BSG (Borosilicate glass) film or BPSG (Borophosphosilicate glass) film can be used. The mixed gas of O₃ and TEOS and TMP (Trimehtylphosphite : P(OCH₃)₃) or TMOP (Trimehtylphosphite : PO(OCH₃)₃) as the gas for thin film deposition where PSG film is deposited, the mixed gas of O₃ and TEOS and TMB (Trimehtylborate : B(OCH₃)₃) as the gas for thin film deposition where BSG film is deposited, and the mixed gas of O₃ and TEOS and TMB and TMP or TMOP as the gas for thin film deposition where BPSG film is deposited can be used.

As described above, according to the present invention, after the surface of the base layer is exposed to the gas for reform of the base layer surface containing a halogen element to reform the surface of the base layer, the thin film deposition is performed on the surface of the base layer reformed by the gas for thin film deposition.

The effect of reform of the base layer surface can be maintained, since the gas for reform of the base layer surface containing a halogen element is used. The micronization and the increase in density of the device can be also realized, since the excellent film in the embedding ability and the step-coverage ability can be deposited on the surface of the base layer 1a having the very narrow-concave regions in width such as the groove.

## Claims

1. A method for reforming a base surface, wherein a surface of a thermal SiO₂ film or a SiO₂ film obtained by a plasma enhanced CVD method and a low pressure CVD method as a base layer (1a), on which base layer (1a) an insulating film (2) is formed after reforming, is exposed to a gas for reforming the surface of the base layer (1a) said gas being selected from the group consisting of AX₄, AHₙCl₄₋ₙ and ARₙX₄₋ₙ (in which, A is selected from the group consisting of Si, Ge and Sn, X is selected from the group consisting of I, Br, F and Cl and R represents any one of CₘH₂ₘ₊₁, and an accompanying character "n" is any one of 1, 2 or 3 and an accompanying character "m" is a natural number), and wherein said base layer (1a) is heated during said reforming step to 100°C or more, and said insulating film (2) is one selected from the group consisting of SiO₂ film, PSG film, BSG film and BPSG film.

2. A method for reforming a base surface according to claim 1, comprising concave regions (3) in said base layer (1a).

3. A method for reforming a base surface according to claim 1, wherein said base layer (1a) is heated, while said surface of the base layer (1a) is exposed to said gas for reforming.

4. A method for reforming a base surface according to claim 1, wherein said AX₄ is any one selected from the group consisting of SiCl₄, SiI₄, SiBr₄ and SiF₄.

5. A method for reforming a base surface according to claim 1, wherein said AHₙCl₄₋ₙ is any one selected from the group consisting of SiHCl₃, SiH₂Cl₂ and SiH₃Cl.

6. A method for reforming a base surface according to claim 1, wherein said ARₙX₄₋ₙ is any one selected from the group consisting of Si(CₘH₂ₘ₊₁)Cl₃, Si(CₘH₂ₘ₊₁)₂Cl₂ and Si(CₘH₂ₘ₊₁)₃Cl (in which, an accompanying character "m" is a natural number).

7. A method for manufacturing semiconductor device according to claim 1, wherein the insulating film (2) is formed on the surface of the base layer (1a) by a chemical vapor deposition method, after reforming the surface of said base layer (1a).

8. A method for manufacturing semiconductor device according to claim 7 wherein a gas for thin film deposition for forming said insulating film is a mixed gas containing at least a TEOS gas and an O₃ gas.

## Patentansprüche

1. Verfahren zum Reformieren einer Grundoberfläche, worin eine Oberfläche eines thermischen SiO₂-Films oder eines SiO₂-Films, erhalten über ein Plasma verstärktes CVD-Verfahren und ein Niederdruck-CVD-Verfahren, als Grundschicht (1a), auf welcher Grundschicht (1a) ein isolierender Film (2) nach dem Reformieren gebildet wird, einem Gas zum Reformieren der Oberfläche der Grundschicht (1a) ausgesetzt wird, wobei das Gas ausgewählt ist aus der Gruppe, bestehend aus AX₄, AHₙCl₄₋ₙ und ARₙX₄₋ₙ (worin A ausgewählt ist aus der Gruppe, bestehend aus Si, Ge und Sn, X ausgewählt ist aus der Gruppe, bestehend aus I, Br, F und Cl, und R für einen Rest CₘH₂ₘ₊₁ steht, und worin der begleitende Buchstabe "n" ein beliebiges aus 1, 2 oder 3 und ein begleitender Buchstabe "m" eine natürliche Zahl ist), und worin die Grundschicht (1a) während des Reformierschrittes auf 100°C oder darüber erwärmt wird und der isolierende Film (2) ein Film ist, ausgewählt aus der Gruppe, bestehend aus einem SiO₂-Film, einem PSG-Film, einem BSG-Film und einem BPSG-Film.

2. Verfahren zum Reformieren einer Grundoberfläche gemäß Anspruch 1, umfassend konkave Bereiche (3) in der Grundschicht (1a).

3. Verfahren zum Reformieren einer Grundoberfläche gemäß Anspruch 1, worin die Grundschicht (1a) erwärmt wird, während die Oberfläche der Grundschicht (1a) dem Gas zum Reformieren ausgesetzt wird.

4. Verfahren zum Reformieren einer Grundoberfläche gemäß Anspruch 1, worin AX₄ ein Element ist, ausgewählt aus der Gruppe, bestehend aus SiCl₄, SiI₄, SiBr₄ und SiF₄.

5. Verfahren zum Reformieren einer Grundoberfläche gemäß Anspruch 1, worin AHₙ CL₄₋ₙ ein Element ist, ausgewählt aus der Gruppe, bestehend aus SiHCl₃, SiH₂Cl₂ und SiH₃Cl.

6. Verfahren zum Reformieren einer Grundoberfläche gemäß Anspruch 1, worin ARₙX₄₋ₙ ein Element ist, ausgewählt aus der Gruppe, bestehend aus Si(CₘH₂ₘ₊₁)Cl₃, Si(CₘH₂ₘ₊₁)₂Cl₂ und Si(CₘH₂ₘ₊₁)₃Cl (worin der begleitende Buchstabe "m" eine natürliche Zahl ist).

7. Verfahren zum Herstellen eines Halbleiterbauteils gemäß Anspruch 1, worin der isolierende Film (2) auf der Oberfläche der Grundschicht (1a) über ein chemisches Dampfabscheidungsverfahren (CVD-Verfahren) nach dem Reformieren der Oberfläche der Grundschicht (1a) gebildet wird.

8. Verfahren zum Herstellen eines Halbleiterbauteils gemäß Anspruch 7, worin ein Gas für die Dünnfilmabscheidung zum Bilden des isolierenden Films ein gemischtes Gas ist, enthaltend mindestens ein TEOS-Gas und ein O₃-Gas.

## Revendications

1. Procédé de reformage d'une surface de base, dans lequel une surface d'un film en SiO₂ thermique ou d'un film en SiO₂ obtenu par un procédé de dépôt chimique en phase vapeur amélioré par plasma ou un procédé de dépôt chimique en phase vapeur à basse pression, comme couche de base (1a), sur laquelle couche de base (1a) est formé un film isolant (2) après le reformage, est exposée à un gaz pour le reformage de la surface de la couche de base (1a), le gaz étant choisi parmi le groupe consistant en AX₄, AHₙCl₄₋ₙ et ARₙX₄₋ₙ (où A est choisi parmi le groupe consistant en Si, Ge et Sn, X est choisi parmi le groupe consistant en I, Br, F et Cl, et R représente un quelconque parmi CₘH₂ₘ₊₄, et le nombre « n » est l'un quelconque parmi 1, 2 ou 3 et le nombre « m » est un nombre naturel), et dans lequel la couche de base (1a) est chauffée pendant l'étape de reformage jusqu'à 100°C ou davantage, et le film. isolant (2) est choisi parmi le groupe consistant en un film en SiO₂, un film en PSG, un film en BSG et un film; en BPSG.

2. Procédé de reformage d'une surface de base suivant la revendication 1, comprenant des régions concaves (3) dans la couche de base (1a).

3. Procédé de reformage d'une surface de baser suivant la revendication 1, dans lequel la couche de base (1a) est chauffée pendant que la surface de la couche de base (1a) est exposée au gaz de reformage.

4. Procédé de reformage d'une surface de basé suivant la revendication 1, dans lequel AX₄ est choisi parmi le groupe consistant en SiCl₄, SiI₄, SiBr₄ et SiF₄.

5. Procédé de reformage d'une surface de base suivant la revendication 1, dans lequel AHₙCl₄₋ₙ est choisi parmi le groupe consistant en SiHCl₃, SiH₂Cl₂ et SiH₃Cl.

6. Procédé de reformage d'une surface de base suivant la revendication 1, dans lequel ARₙX₄₋ₙ est choisi parmi le groupe consistant en Si(CₘH₂ₘ₊₁)Cl₃, Si(CₘH₂ₘ₊₁)₂Cl₂ et Si(CₘH₂ₘ₊₁)₃Cl (où le nombre « m » est un nombre naturel).

7. Procédé de préparation d'un dispositif semiconducteur suivant la revendication 1, dans lequel le film isolant (2) est formé sur la surface d'une couche de base (1a) par un procédé de dépôt chimique en phase vapeur, après reformage de la surface de la couche de base (1a).

8. Procédé de préparation d'un dispositif semiconducteur suivant la revendication 7, dans lequel un gaz pour le dépôt de film fin pour former le film isolant est un gaz mixte contenant au moins du TEOS gazeux et du O₃ gazeux.
